# EUROPÄISCHE PATENTANMELDUNG

(11) **EP 4 733 433 A1**
(43) Veröffentlichungstag der Anmeldung: **29.04.2026**
(21) Anmeldenummer: 25208954.5
(22) Anmeldetag: 15.10.2025
(51) Int. Cl.: C23C 16/04, C23C 16/44, C23C 16/455, C23C 16/458, C23C 16/511, H01J 37/32, F16C 33/20

(54) **PLASMABEHANDLUNGSSTATION UND PLASMABEHANDLUNGSANLAGE**

(30) Priorität: 18.10.2024 DE 102024130353
(71) Anmelder: KHS GmbH, 44143 Dortmund (DE)
(72) Erfinder: Schetle, Andreas, 44143 Dortmund (DE)
(74) Vertreter: Andrejewski - Honke Patent- und Rechtsanwälte Partnerschaft mbB

(57) **Zusammenfassung**

Die Erfindung betrifft eine Plasmabehandlungsstation (2) mit einem Behandlungsraum (4), mit einem innerhalb des Behandlungsraums angeordneten ersten Teil und mit einem entlang einer Kontaktfläche an dem ersten Teil anliegenden und zu diesem relativ beweglichen zweiten Teil. Die Erfindung betrifft außerdem eine Plasmabehandlungsanlage (1) umfassend eine entsprechende Plasmabehandlungsstation (2). Erfindungsgemäß ist entweder das erste Teil im Bereich der Kontaktfläche aus einem hochmolekularen Polyethylen mit einer mittlere Molmasse von zumindest 500.000 g/mol gebildet und das zweite Teil im Bereich der Kontaktfläche Polyetheretherketon (PEEK) gebildet ist oder das erste Teil im Bereich der Kontaktfläche aus Polyetheretherketon (PEEK) und das zweite Teil im Bereich der Kontaktfläche aus einem hochmolekularen Polyethylen mit einer mittleren Molmasse von zumindest 500.000 g/mol gebildet.

## Beschreibung

Die Erfindung betrifft eine Plasmabehandlungsstation mit einem Behandlungsraum, mit einem innerhalb des Behandlungsraums angeordneten ersten Teil und mit einem entlang einer Kontaktfläche an dem ersten Teil anliegenden und zu diesem relativ beweglichen zweiten Teil. Die Erfindung betrifft außerdem eine Plasmabehandlungsanlage umfassend eine entsprechende Plasmabehandlungsstation.

Insbesondere betrifft die Erfindung eine Plasmabehandlungsstation zur Oberflächenbehandlung zumindest eines Werkstücks. Diese ist dazu eingerichtet, innerhalb des Behandlungsraums ein Plasma zu zünden und hierdurch die Oberfläche des Werkstücks zu behandeln.

Insbesondere bezieht sich die Erfindung auf eine Plasmabeschichtungsanlage, bei der auf das Werkstück eine Beschichtung unter Vermittlung eines Plasmas aufgebracht wird. Hierbei kann es sich insbesondere um das sogenannte PIVCD-Verfahren handeln. Darunter ist ein sogenanntes Plasma-Induziertes Chemical Vapour Deposition-Verfahren zu verstehen, bei dem in den Behandlungsraum zumindest ein Prozessgas eingeleitet wird. Dieses wird unter Einwirkung eines in dem Behandlungsraum gezündeten Plasmas aufgespalten und scheidet chemische Verbindungen ab, die sich an dem zu beschichtenden Werkstück anlagern. Hierzu müssen innerhalb des Behandlungsraums geeignete Bedingungen zur Zündung eines Plasmas geschaffen werden. Neben der stofflichen Zusammensetzung dieser Behandlungsatmosphäre können auch geeignete Druckverhältnisse erzeugt werden.

Die Zündung des Plasmas erfolgt insbesondere über die Einkopplung elektromagnetischer Wellen, insbesondere Mikrowellen in den Behandlungsraum. Dieser stellt dazu zumindest in einem geschlossenen Zustand einen eltrischen Abschluss her. Dadurch bildet der Behandlungsraum eine Kavität, innerhalb derer die elektromagnetischen Wellen, insbesondere Mikrowellen wirken können. Die Geometrie und die elektromagnetischen Wellen werden derart aufeinander abgestimmt, dass lokal hohe Feldstärken und/oder Energiedichten auftreten, die das Zünden eines Plasmas ermöglichen. Die Erfindung ist allerdings nicht allein auf Plasmabeschichtungsprozesse beschränkt, sondern kann allgemein im Umfeld von Plasmabehandlungen - wie beispielsweise Koronaentladungen - eingesetzt werden.

Ein Plasmabehandlungsverfahren ist gemein, dass das zu behandelnde Werkstück - bei dem es sich insbesondere um einen Behälter, vorzugsweise aus Kunststoff handeln kann - innerhalb des Behandlungsraums positioniert werden muss. Hierzu sind zusätzliche in dem Behandlungsraum hineinreichende Einbauten, insbesondere Werkstückhalter erforderlich. Da leitfähige Einbauten aus metallischen Werkstoffen störende Einflüsse auf das elektrische Feld und damit auf die Ausbreitung der elektromagnetischen Wellen haben, werden diese Einbauten bevorzugt aus sogenannten dielektrischen Kunststoffmaterialien gefertigt. Diese verursachen lediglich eine geringfügige Verzerrung des elektrischen Feldes, sodass eine zuverlässige und gezielte Plasma-Zündung nicht wesentlich behindert wird. Aufgrund der hohen Beständigkeit und guten Dielektrizität wird hierzu üblicherweise das Kunststoffmaterial PEEK (Polyetheretherketon) eingesetzt.

Es hat sich jedoch gezeigt, dass relativ zueinander bewegliche Teile - insbesondere im Rahmen von Gleitlagern - sich aus diesem Material nur schwer darstellen lassen. Aufgrund des einsetzenden hohen Verschleißes ist dadurch ein Austausch der beweglichen Teile bereits nach wenigen hundert Betriebsstunden erforderlich.

Vor diesem Hintergrund liegt der Erfindung die Aufgabe zugrunde, den Verschleiß von beweglichen Teilen in einer Plasmabehandlungsstation zu reduzieren und dadurch die Langlebigkeit der Komponenten zu erhöhen. Gegenstand der Erfindung und Lösung dieser Aufgabe ist eine Plasmabehandlungsstation nach dem Anspruch 1 sowie eine Plasmabehandlungsanlage nach dem Anspruch 12. Bevorzugte Ausgestaltungen sind jeweils in den abhängigen Unteransprüchen angegeben.

Ausgehend von der gattungsgemäßen Plasmabehandlungsstation ist erfindungsgemäß vorgesehen, dass das erste Teil im Bereich der Kontaktfläche aus einem hochmolekularen Polyethylen mit einer mittlere Molmasse von zumindest 500.000 g/mol gebildet ist und dass das zweite Teil im Bereich der Kontaktfläche Polyetheretherketon (PEEK) gebildet ist oder dass alternativ das erste Teil im Bereich der Kontaktfläche aus Polyetheretherketon (PEEK) und das zweite Teil im Bereich der Kontaktfläche aus einem hochmolekularen Polyethylen mit einer mittleren Molmasse von zumindest 500.000 g/mol gebildet ist.

Im Bereich der Kontaktfläche meint dabei, dass die Oberfläche des ersten Teils in dem Bereich, welche mit dem zweiten Teil in Kontakt kommt bzw. die Oberfläche des zweiten Teils, in dem Bereich, welche mit dem ersten Teil in Kontakt kommt, zu zumindest 90 Gew.-%, vorzugsweise zumindest 95 Gew.-%, insbesondere vollständig aus dem jeweils angegebenen Kunststoffmaterial gebildet ist.

Die erfindungsgemäße Materialpaarung hat den Vorteil, dass beide Kunststoffe (hochmolekulares PE und PEEK) ähnliche elektrische Eigenschaften haben. Gleichzeitig haben Sie ebenfalls ähnliche, jedoch nicht vollständig identische mechanische Eigenschaften. Dabei ist das hochmolekulare Polyethylen geringfügig weicher und verschleißanfälliger als das PEEK. Dies hat zur Folge, dass bei einer Relativbewegung des ersten Teils zu dem zweiten Teil entlang der Kontaktfläche der reibungsbedingte Verschleiß auf dasjenige aus Polyethylen gebildete Teil konzentriert wird. Im Verschleißfall kann dabei der Austausch zumindest auf eins der beiden Teile beschränkt werden. Gleichzeitig führt der Abrieb beim Verschleißen des PE zu einer Selbstschmierung, welche insbesondere dazu geeignet ist auch einen geringfügigen Eintrag von Fremdstoffen auszugleichen. Durch den Verschleiß des PE wird zusätzlich Raum geschaffen, der Einem Zusetzen entgegenwirkt. Das erste Teil und das zweite Teil bleiben dadurch länger leichtgängig gegeneinander beweglich und einsatzfähig.

Gemäß einer bevorzugten Ausgestaltung der Erfindung ist das hochmolekulare Polyethylene als PE-HMW oder PE 500 mit einer mittleren Molmasse zwischen 500.000 g/mol und 1.000.000 g/mol ausgestaltet. Dieser Werkstoff stellt zusammen mit dem PEEK einen optimalen Partner da, welcher die erfindungsgemäßen Eigenschaften besonders gut zur Geltung bringt. Gleichzeitig stellt das PEHMW bzw. PE 500 mit einer Molmasse von nicht mehr als 1.000.000 g/mol eine sowohl wirksame als vergleichsweise auch kosteneffiziente Option dar.

Gemäß einer bevorzugten Ausgestaltung der Erfindung, bilden das erste und das zweite Teil ein Gleitlager, insbesondere für ein Rotations- und/oder Linearbewegung. Durch den Verzicht auf metallische Werkstoffe innerhalb des Behandlungsraums ist die Ausbildung von Wälzlagern oder komplexeren Lagertypen in der Regel nicht wünschenswert. Damit werden einfache Gleitlager mit einem flächigen Kontakt zwischen einem ersten Teil und einem zweiten Teil besonders erstrebenswert. Durch die vorteilhafte erfindungsgemäße Materialpaarung kann die Leistungsfähigkeit und Lebensdauer entsprechender Gleitlager signifikant erhöht werden.

Vorzugsweise weist die Plasmabehandlungsstation zumindest eine Werkstückhalterung auf. Diese ist insbesondere dazu eingerichtet, ein Werkstück an der Behandlungsstation, insbesondere in dem Behandlungsraum, während einer Plasmabehandlung zu halten. Bei dem Werkstück kann sich insbesondere um einen Behälter, vorzugsweise ein Kunststoffbehälter handeln, sodass die Werkstückhalterung auch als Behälterhalterung zum Halten eines solchen Behälters bezeichnet werden kann.

Gemäß einer bevorzugten Ausführungsform ist die Werkstückhalterung Teil einer Halte- und Dichtvorrichtung der Plasmabehandlungsstation. Anders ausgedrückt weist die Plasmabehandlungsstation eine Halte- und Dichtvorrichtung mit einem eine Dichtung aufweisenden Dichtungsträger und mit einer in einer Hubbewegung zwischen einer Grundposition und einer Dichtposition relativ zu dem Dichtungsträger verlagerbaren Werkstückhalterung zum Halten eines Werkstücks, insbesondere Behälters, auf. Weiterhin ist das erste Teil als Führungsbolzen ausgebildet, und das zweite Teil bildet eine Aufnahme aus, wobei die Hubbewegung mittels des die Aufnahme durchgreifenden Führungsbolzens geführt ist. Dabei wird der Führungsbolzen formschlüssig von der Aufnahme umgriffen und bildet somit ein in einer Längserstreckung des Führungsbolzens wirksames lineares Gleitlager aus. Durch die Hubbewegung können der Dichtungsträger und die Werkstückhalterung aufeinander zu und auseinander verlagert werden, um beispielsweise das Werkstück, insbesondere den Behälter auf eine in den Dichtungsträger aufgenommene Dichtung zu drücken und diesen zur Entnahme wieder zu entlasten.

Dabei kann im Rahmen der Erfindung bevorzugt vorgesehen sein, dass der das erste Teil bildende Führungsbolzen an den Dichtungsträger angeordnet ist und dass die Werkstückhalterung das zweite Teil bildet, welches die Aufnahme ausbildet. Alternativ kann der erste Teil bildende Führungsbolzen an der Werkstückhalterung angeordnet sein und das zweite Teil durch den Dichtungsträger gebildet sein, welcher seinerseits die Aufnahme bildet. Auch sind Ausgestaltungen in beiden Richtungen und/oder mit mehreren Kombinationen aus Führungsbolzen und Aufnahmen von dieser Ausführungsform der Erfindung mit umfasst.

Gemäß einer besonders bevorzugten Ausgestaltung ist der Führungsbolzen austauschbar ausgestaltet. Dadurch kann dieser separat von den übrigen Komponenten innerhalb der Plasmabehandlungsstation ausgetauscht werden - etwa wenn dieser beschädigt oder verschlissen ist. Dies ist insbesondere dann sinnvoll, wenn der das erste Teil bildende Führungsbolzen aus dem hochmolekularen Polyethylen-Material gebildet ist.

Gemäß einer besonders bevorzugten Ausgestaltung ist an dem Führungsbolzen zumindest ein, vorzugsweise materialverschiedenes, Anschlagstück angeordnet, welches in einer Sperrposition die Hubbewegung begrenzt und in einer Freigabeposition durch die Aufnahmen hindurchgeführt werden kann. Dadurch, dass das Anschlagstück zwischen einer Freigabe- und einer Sperrposition bewegbar ist, kann die Halte- und Dichtvorrichtung zu Wartungszwecken besonders einfach demontiert und zur Benutzung zusammengesetzt werden.

Gemäß einer besonders bevorzugten Ausgestaltung ist der Führungsbolzen aus einem Polyethylen-Material gebildet, während sowohl das die Aufnahme ausbildende zweite Teil als auch das Anschlagelement aus PEEK gebildet sind. Hierdurch wird eine besonders gute Langlebigkeit erzielt. Insbesondere kann das Anschlagstück austauschbar an dem Führungsbolzen befestigt sein. So ist beim Austausch des Führungsbolzens möglich, dass Anschlagstück auf das Austauschteil zu übertragen und so eine weitere Materialersparnis zu erzielen.

Gemäß einem weiteren bevorzugten Aspekt der Erfindung weist die Werkstückhalterung einen eine Werkstückaufnahme ausbildenden Träger und ein Halteelement auf, welches über ein Gleitlager beweglich an dem Träger geführt wird. Das Gleitlager weist eine erste Lagerfläche auf, an der das Halteelement mit einer zweiten Lagerfläche anliegt. Gemäß diesem Aspekt der Erfindung wird die erste Lagerfläche durch das erste Teil und die zweite Lagerfläche durch das zweite Teil gebildet. Durch die erfindungsgemäße Materialpaarung kann die Beweglichkeit des Halteelements an dem Träger für einen langen Zeitraum gewährleistet werden.

Die Beweglichkeit des Halteelements ist insbesondere dazu vorgesehen, um zwischen einer geschlossenen Halteposition und einer geöffneten Position bewegt zu werden. In der geschlossenen Postion verhindert das Halteelement eine Entnahme eines Werkstücks, welches in die Werkstückaufnahme eingesetzt ist.

Dabei kann das Werkstück form- kraft- und/oder reibschlüssig gehalten werden. In der geöffneten Position ist eine Entnahme bzw. ein Einsetzen des Werkstücks möglich.

Es ist hierbei einerseits denkbar, dass das Halteelement passiv beweglich und durch Kraftrückstellung in die geschlossene Position (Halteposition) bewegt wird oder aktiv mittels eines Antriebs gesteuert wird. Die Beweglichkeit zwischen dem Halteelement und der Werkstückaufnahme bedingt jedoch eine relative Beweglichkeit, welche insbesondere durch die erfindungsgemäße Materialpaarung bereitgestellt werden kann.

Bevorzugt ist das erste Teil ein den Träger mit dem Halteelement verbindender Lagerbolzen und das zweite Teil das Halteelement. Der Lagerbolzen stellt dabei die erste Lagerfläche bereit, an der das Halteelement mit der zweiten Lagerfläche geführt ist.

Vorzugsweise ist der Lagerbolzen austauschbar an dem Träger gehalten. Dabei ist der Lagerbolzen ganz besonders bevorzugt dasjenige Teil, welches aus dem hochmolekularen Polyethylen gebildet ist.

Gemäß einer weiter bevorzugten Ausgestaltung der Erfindung ist die erste Lagerfläche und/oder die zweite Lagerfläche unterbrochen ausgebildet. Dadurch kann zusätzlich das Zusetzen des Gleitlagers geometrisch-mechanisch unterbunden werden.

Im Rahmen der Erfindung kann ausdrücklich vorgesehen sein, dass an mehreren Stellen der Plasmabehandlungsstation die erfindungsgemäße Materialpaarung aus jeweils einem "ersten Teil" und einem "zweiten Teil" beweglich aneinander anliegen. Die Zuordnung ist dabei jeweils nur isoliert auf die jeweilige Kontaktstelle bzw. das jeweilige Gleitlager zu verstehen.

Ein weiterer bevorzugter Aspekt der Erfindung betrifft eine Plasmabehandlungsanlage mit einer Mikrowellenquelle, wobei erfindungsgemäß eine an die Mikrowellenquelle angeschlossene Plasmabehandlungsstation vorgesehen ist, wie diese zuvor beschrieben ist. Durch die erfindungsgemäße Materialpaarung zwischen dem hochmolekularen Polyethylen und dem PEEK wird eine besonders gute Langlebigkeit und Resistenz gegen Verschleiß erzielt.

Gemäß einer besonders bevorzugten Ausgestaltung der Erfindung handelt es sich bei der Plasmabehandlungsanlage und um eine Plasmabeschichtungsanlage. Diese ist insbesondere dazu eingerichtet nach dem PIVCD-Prozess zu arbeiten. Dazu sind zusätzlich Einrichtungen vorgesehen, um den Behandlungsraum zu evakuieren und diesen mit einem Reaktionsgas zu beaufschlagen.

Die Erfindung wird nachfolgend anhand von lediglich ein Ausführungsbeispiel darstellenden Figuren erläutert. Es zeigen dabei schematisch:
- Fig. 1: eine schematische Darstellung einer erfindungsgemäßen Plasmabehandlungsanlage,
- Fig. 2: eine perspektivische Darstellung der darin vorgesehenen Halte- und Dichtvorrichtung,
- Fig. 3A: eine perspektivische Darstellung der erfindungsgemäßen Werkstückhalterung und
- Fig. 3B: eine Explosionsdarstellung der erfindungsgemäßen Werkstückhalterung aus Fig. 3A

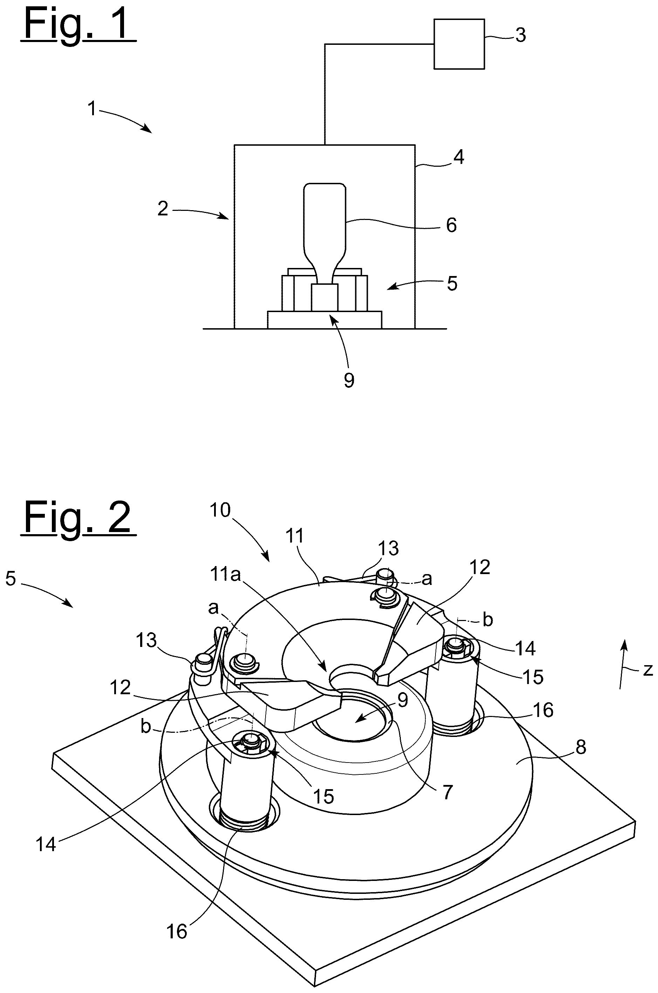

Die Fig. 1 zeigt eine erfindungsgemäße Plasmabehandlungsanlage 1 mit einer Plasmabehandlungsstation 2 und einer an die Plasmabehandlungsstation 2 angeschlossenen Mikrowellenquelle 3. Die Plasmabehandlungsstation 2 weist eine an die Mikrowellenquelle 3 angeschlossenen Behandlungsraum 4 auf, welcher in Fig. 1 schematisch in einer geschlossenen Position dargestellt ist. In den geschlossenen Behandlungsraum 4 hinein erstreckt sich eine Halte- und Dichtvorrichtung 5, an der ein Werkstück, nämlich ein Behälter 6 aufgenommen ist.

Die Halte- und Dichtvorrichtung 5 zum Halten und Abdichten des Behälters 6 in der Plasmabehandlungsstation 2 ist in größerem Detail in Fig. 2 dargestellt: Diese umfasst einen eine Dichtung 7 aufweisenden Dichtungsträger 8. In dem dargestellten Ausführungsbeispiel wird der Dichtungsträger 8 durch eine ortsfest an der Plasmabehandlungsstation 2 angeordnete Grundplatte gebildet. Zentral innerhalb der Dichtung 7 ist eine Öffnung 9 ausgebildet, durch die insbesondere Prozessgase in das Innere des Behälters 6 eingeleitet werden können.

Die Halte- und Dichtvorrichtung 5 umfasst ferner eine Werkstückhalterung 10 zum Halten des Behälters 6, welche in einer Hubbewegung zwischen einer Grundposition und einer Dichtposition gegenüber dem Dichtungsträger 8 verlagert werden kann. Fig. 2 zeigt dabei die Grundposition zur besseren Sichtbarkeit ohne den Behälter 6. In der Grundposition weisen der Dichtungsträger 8 und die Werkstückhalterung 10 zueinander einen größeren Abstand auf als in der Dichtposition, bei der ein an der Werkstückhalterung 10 aufgenommener Behälter 6 an der Dichtung 7 dichtend anliegt

Zur Aufnahme des Behälters 6 weist die Werkstückhalterung 10 einen eine Werkstückaufnahme 11a ausbildenden Träger 11 sowie zwei gegenüber dem Träger 11 bewegliche Halteelemente 12 auf. In dem dargestellten Ausführungsbeispiel sind die beiden Halteelemente 12 mit je einem Haltefinger 12b ausgebildet und um vertikal verlaufende Drehachsen a drehbar gehalten. Durch rückwärtig an die Halteelemente 12 angreifende elastische Rückstellelemente 13 wird eine Schwenkbewegung in Richtung der Werkstückaufnahme 11a bewirkt, sodass ein in die Werkstückaufnahme 11a eingelegter Behälter 6 durch Kraftbeaufschlagung der Halteelemente 12 gehalten wird.

Die Werkstückhalterung 10 - und gegebenenfalls ein daran gehaltener Behälter 6 - sind in einer Hubbewegung gegenüber dem Dichtungsträger 8 verlagerbar. Dazu ist vorgesehen, dass während eines Plasma-(Beschichtungs-)Prozesses der Behälter 6 zunächst in die Werkstückhalterung 10 eingesetzt wird, während diese die in der Figur dargestellte Grundposition einnimmt. In dieser verbleibt zwischen der Mündung des Behälters 6 und der Dichtung 7 in der Vertikalrichtung z ein Abstand, während die Mündung bereits mit der Öffnung 9 innerhalb der Dichtung 7 fluchtet.

Anschließend wird die Werkstückhalterung 10 mit dem daran aufgenommenen Behälter 6 auf den Dichtungsträger 8 zu bewegt, sodass die Mündung des Behälters 6 mit der Dichtung 7 in Kontakt tritt und damit zwei Volumina innerhalb und außerhalb des Behälters 6 voneinander abteilt. Durch Evakuieren des Innenraums der Kavität 4 werden Bedingungen hergestellt, unter denen ein Plasma zünden kann, wobei der Druck innerhalb und außerhalb des Behälters 6 aneinander angeglichen wird, um eine ungewollte Verformung des Behälters 6 zu verhindern.

Zumindest eins der beiden Volumina innerhalb oder außerhalb des Behälters 6 wird anschließend mit einem Prozessgas bzw. Gasgemisch gespült, aus dem durch Mikrowellen-induziertes Zünden eines Plasmas innerhalb der Kavität 4 Beschichtungsmoleküle abgespalten werden, die sich an der Oberfläche des Behälters 6 anlagern.

Die unterschiedliche Stoffzusammensetzung des bzw. der Prozessgase und unterschiedliche Charakteristiken beim Eintrag der Mikrowellenenergie können dabei Schichten unterschiedlicher Abmessung und Zusammensetzung erzeugen. Diese können insbesondere in einem mehrstufigen Prozess zu mehrlagigen Beschichtungen kombiniert werden. Beispielsweise wird zunächst eine Haftvermittlerschicht auf das Substrat des Behälters - in der Regel ein Kunststoff, insbesondere Polyethylenterephthalat (PET) - aufgebracht. Die Haftvermittlerschicht wird anschließend mit einer die hauptsächliche Barrierewirkung vermittelnden Barriereschicht überzogen und anschließend durch eine obere Schutzschicht - das sogenannte Topcoating - abgeschlossen und versiegelt.

Zum Entnehmen des behandelten, insbesondere beschichteten Behälters 6 werden die Werkstückhalterung 10 und der Dichtungsträger 8 in einer Hubbewegung voneinander entfernt, sodass der Behälter 6 den Kontakt zur Dichtung 7 verliert und mit geringem mechanischen Aufwand aus der Werkstückhalterung 10 entnommen werden kann.

Die Hubbewegung ist mittels zweier Führungsbolzen 14 geführt, welche an dem Dichtungsträger 8 angeordnet sind und zugeordnete Aufnahmen 15 der Werkstückhalterung 10 durchgreifen. In dem dargestellten Ausführungsbeispiel sind die Führungsbolzen 14 in der Vertikalrichtung z ausgerichtet und ermöglichen so eine lineare Führung der Werkstückhalterung 10 an dem Dichtungsträger 8. Die Hubbewegung ist dabei durch zwei Schraubenfedern 16 in der Vertikalrichtung nach oben vorgespannt. Eine Verlagerung aus der dargestellten Grundposition in die Dichtposition erfolgt gegen die Rückstellkraft der Schraubenfedern 16.

An den Führungsbolzen 14 ist jeweils ein Anschlagstück 17 angeordnet, welches in einer Sperrposition die Hubbewegung begrenzt und in Freigabeposition durch die Aufnahme 15 hindurchgeführt werden kann. Hierdurch ist es möglich, die Werkstückhalterung 10 zu Wartungszwecken gänzlich von dem Dichtungsträger 8 zu entfernen und beispielsweise zu reinigen oder durch ein Austauschteil zu ersetzen.

Der Führungsbolzen 14 weist eine äußere zylindersymmetrische Führungsfläche auf, innerhalb derer dieser als Vollbolzen ausgefüllt ist. Das Volumen innerhalb der äußeren Führungsfläche wird vollständig durch das Material des Führungsbolzens 14 ausgefüllt.

Die Erfindung wird in dem dargestellten Ausführungsbeispiel gleich zweifach verwirklicht: Gemäß einem ersten Teilaspekt bilden die Führungsbolzen 14 jeweils das erste Teil aus einem hochmolekularen Polyethylen, während das die Aufnahmen 15 umgebenden Material der Werkstückhalterung 10 das zweite Teil aus Polyetheretherketon (PEEK) bildet. Dadurch wird das lineare Gleitlager für die Hubbewegung vor einem Zusetzen geschützt.

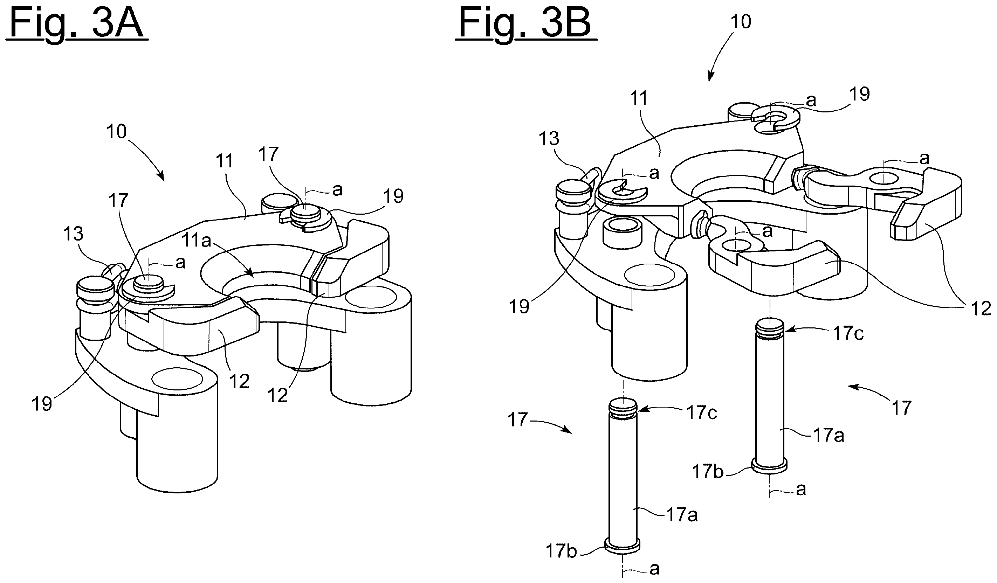

Di zweite erfindungsgemäße Ausgestaltung ist in den Fig. 3A und 3B dargestellt. Das Haltelement 12 ist an dem Träger 11 durch einen Lagerbolzen 18 drehbar befestigt. Der Lagerbolzen 18 weist dabei eine um die Drehachse a zylindersymmetrisch verlaufende erste Lagerfläche 18a auf, welche im zusammengesetzten Zustand mit einer zylindersymmetrischen Innenfläche 12a des Halteelements 12 zusammenwirkt und in Anlage ist. Gemäß dieser zweiten Verwirklichung der Erfindung ist der Lagerbolzen 18, welcher gleichzeitig ein erstes Teil bildet, vollständig aus einem Polyethylen mit hohem Molekulargewicht, insbesondere PE 500 ausgebildet. Entsprechend ist das Halteelement 12, welches gleichzeitig das zweite Teil bildet vollständig aus Polyetheretherketon (PEEK) gebildet.

Im unteren Bereich des Lagerbolzens ein umlaufender Vorsprung 18b gebildet, welcher ein Herausziehen nach oben verhindert. Im oberen Bereich ist korrespondierend eine Sicherungsnut 18c ausgebildet, in die ein Sicherungselement in Gestalt eines Sprengrings 19 eingesetzt werden kann.

### Bezugszeichenliste:

- 1: Plasmabehandlungsanlage
- 2: Plasmabehandlungstation
- 3: Mikrowellenquelle
- 4: Behandlungsraum
- 5: Halte- und Dichtvorrichtung
- 6: Behälter
- 7: Dichtung
- 8: Dichtungsträger
- 9: Öffnung
- 10: Werkstückhalterung
- 11: Träger
- 11a: Werkstückaufnahme
- 12: Halteelement
- 12a: innere Lagerfläche
- 12b: Haltefinger
- 13: elastisches Rückstellelement
- 14: Führungsbolzen
- 15: Aufnahme
- 15a: innere Anlagefläche
- 16: Federelement, Schraubenfeder
- 17: Anschlagstück
- 18: Lagerbolzen
- 18a: erste Lagerfläche
- 18b: unterseitiger Vorsprung
- 18c: Sicherungsnut
- 19: Sprengring
- a: Drehachse
- z: Vertikalrichtung

## Patentansprüche

1. Plasmabehandlungsstation (2) mit einem Behandlungsraum (4), mit einem innerhalb des Behandlungsraums (4) angeordneten ersten Teil und mit einem entlang einer Kontaktfläche an dem ersten Teil anliegenden und zu diesem relativ beweglichen zweiten Teil, **dadurch gekennzeichnet, dass** das erste Teil im Bereich der Kontaktfläche aus einem hochmolekularen Polyethylen mit einer mittleren Molmasse von zumindest 500.000 g/mol gebildet ist und dass das zweite Teil im Bereich der Kontaktfläche aus Polyetheretherketon (PEEK) gebildet ist oder dass das erste Teil im Bereich der Kontaktfläche aus Polyetheretherketon (PEEK) und das zweite Teil im Bereich der Kontaktfläche aus einem hochmolekularen Polyethylen mit einer mittleren Molmasse von zumindest 500.000 g/mol gebildet ist.

2. Plasmabehandlungsstation (2) nach dem vorangegangenen Anspruch, **dadurch gekennzeichnet, dass** hochmolekulare Polyethylen als PE-HMW oder PE500 mit einer mittleren Molasse zwischen 500.000 g/mol und 1.000.000 g/mol ausgestaltet ist.

3. Plasmabehandlungsstation (2) nach einem der vorangegangenen Ansprüche, **dadurch gekennzeichnet, dass** das erste Teil und das zweite Teil ein Gleitlager, insbesondere für eine Rotations- und/oder Linearbewegung bilden.

4. Plasmabehandlungsstation (2) nach einem der vorangegangenen Ansprüche, **gekennzeichnet durch** zumindest eine Werkstückhalterung (10) zum Halten eines Werkstücks, insbesondere Behälters (6), in dem Behandlungsraum (4).

5. Plasmabehandlungsstation (2) nach dem vorangegangenen Anspruch, **dadurch gekennzeichnet, dass** die Werkstückhalterung (10) Teil einer Halte- und Dichtvorrichtung (5) mit einem eine Dichtung (7) aufweisenden Dichtungsträger (8) ist, dass die Werkstückhalterung (10) mit einer in einer Hubbewegung zwischen einer Grundposition und einer Dichtposition relativ zu dem Dichtungsträger (8) verlagerbar ist, dass das erste Teil als Führungsbolzen (14) ausgebildet ist, dass das zweite Teil eine Aufnahme (15) ausbildet und dass die Hubbewegung mittels des die Aufnahme (15) durchgreifenden Führungsbolzens (14) geführt ist.

6. Plasmabehandlungsstation (2) nach dem vorangegangenen Anspruch, **dadurch gekennzeichnet, dass** der Führungsbolzen (14) aus hochmolekularem Polyethylen mit einer Molmasse von zumindest 500.000 g/mol gebildet ist.

7. Plasmabehandlungsstation (2) nach einem der vorangegangenen Ansprüche 5 oder 6, **dadurch gekennzeichnet, dass** der Führungsbolzen (14) austauschbar ausgebildet ist.

8. Plasmabehandlungsstation (2) nach einem der vorangegangenen Ansprüche 5 bis 7, **dadurch gekennzeichnet, dass** an dem Führungsbolzen zumindest ein, vorzugsweise materialverschiedenes, Anschlagstück (17) angeordnet ist, welches in einer Sperrposition die Hubbewegung begrenzt und in einer Freigabeposition durch die Aufnahme (15) hindurchgeführt werden kann.

9. Plasmabehandlungsstation nach einem der vorangegangenen Ansprüche 3 bis 8, **dadurch gekennzeichnet, dass** die Werkstückhalterung (10), einen eine Werkstückaufnahme (11a) ausbildenden Träger (11) und ein Halteelement (12) aufweist, welches über ein Gleitlager beweglich an dem Träger geführt wird, dass das Gleitlager eine erste Lagerfläche (18a) aufweist, an der das Halteelement (12) mit einer zweiten Lagerfläche (12a) anliegt, und dass die erste Lagerfläche (18a) durch das erste Teil und die zweite Lagerfläche (12a) durch das zweite Teil gebildet wird.

10. Plasmabehandlungsstation (2) nach dem vorangegangenen Anspruch, **dadurch gekennzeichnet, dass** das erste Teil ein den Träger mit dem Halteelement (12) verbindender Lagerbolzen (18) ist und dass das zweite Teil das Halteelement (12) ist.

11. Plasmabehandlungsstation (12) nach dem vorangegangen Anspruch, **dadurch gekennzeichnet, dass** der Lagerbolzen (12) austauschbar an dem Träger (11) gehalten ist.

12. Plasmabehandlungsstation (2) nach einem der vorangegangenen Ansprüche 9 bis 11, **dadurch gekennzeichnet, dass** die erste Lagerfläche und/oder die zweite Lagerfläche unterbrochen ausgebildet ist.

13. Plasmabehandlungsanlage (1) mit einer Mikrowellenquelle (3), **gekennzeichnet durch** eine an die Mikrowellenquelle (3) angeschlossene Plasmabehandlungsstation (2) nach einem der vorangegangenen Ansprüche.
